Europäisches Patentamt

European Patent Office

Office européen des brevets

(11) Veröffentlichungsnummer: **0 315 852**
**A2**

# (12) EUROPÄISCHE PATENTANMELDUNG

(21) Anmeldenummer: 88118078.0

(51) Int. Cl.⁴: **H05K 1/05**

(22) Anmeldetag: 31.10.88

(30) Priorität: 07.11.87 DE 3737889

(43) Veröffentlichungstag der Anmeldung:
17.05.89 Patentblatt 89/20

(84) Benannte Vertragsstaaten:
CH DE FR GB IT LI NL

(71) Anmelder: **BASF Aktiengesellschaft**
**Carl-Bosch-Strasse 38**
**D-6700 Ludwigshafen(DE)**

(72) Erfinder: **Muenstedt, Helmut, Dr.**
**An dem Altenbach 41**
**D-6706 Wachenheim(DE)**

(54) Leiterplattensubstrate mit verbesserter Wärmeleitfähigkeit.

(57) Leiterplattensubstrat mit guter Wärmeleitfähigkeit, aufgebaut aus einem Verbund aus

A) einem elektrisch und thermisch isolierenden Kunststoff und

B) einem mit thermisch gut leitfähigen Füllstoffen ausgerüsteten Kunststoff.

EP 0 315 852 A2

## Leiterplattensubstrate mit verbesserter Wärmeleitfähigkeit

Die Erfindung betrifft Leiterplattensubstrate mit guter Wärmeleitfähigkeit, aufgebaut aus einem Verbund aus

A) einem elektrisch und thermisch isolierenden Kunststoff und

B) einem mit thermisch gut leitfähigen Füllstoffen ausgerüsteten Kunststoff.

Die hohe Packungsdichte elektronischer Bauteile in modernen elektronischen Schaltungen bringt es mit sich, daß trotz der geringen Wärme, die von einem einzelnen Bauteil ausgeht, insgesamt starke Wärmeströme abzuführen sind. Da herkömmliche Leiterplattensubstrate (z. B. Epoxyharze) wie auch die neuerdings größeres Interesse findenden hochtemperaturbeständigen Thermoplaste in der Regel schlechte Wärmeleiter sind, kann die Wärme nur unvollkommen über das Leiterplattensubstrat abgeführt werden. Dadurch entsteht eine lokale Erwärmung und als Folge eine hohe thermische Überbeanspruchung der elektronischen Bauteile, die deren einwandfreie Funktion beeinträchtigen und zu einer vorzeitigen Alterung und damit zum Ausfall des Bauteils führen kann.

Zur Lösung dieses Problems wurden bereits Verbundplatten aus Metallen und keramischen Materialien entwickelt, die auch kommerziell erhältlich sind (im Handel befindlich sind keramikbeschichtete Stahlplatten). Diese erfordern jedoch eine aufwendige Verarbeitungstechnologie, besitzen ein hohes Gewicht und weisen darüber hinaus auch häufig nicht ausreichende Haftfestigkeiten zwischen den beiden artverschiedenen Materialien Metall und Keramik auf, die die Verbundplatte bilden.

Eine weitere Möglichkeit ist der Einbau von Wärmesenken, z. B. die Anbringung von durchgehenden metallisierten Bohrungen bei Leiterplatten, die auf einer Seite eine durchgehende Metallbeschichtung aufweisen. Die Bohrungen verbinden in diesem Fall das elektronische Bauteil mit der auf der gegenüberliegenden Seite des Substrats befindlichen Metallschicht, was zu einer Verbesserung der Wärmeableitung führt. Solche Systeme sind z. B. in F.N. Sinnadarai; Handbook of Microelectronics Packaging and Interconnection Technologies, Electrochemical Publications Ltd., Agr, Scotland, 1985 auf Seite 243 beschrieben.

Aufgrund des relativ komplizierten und nicht einfach herzustellenden Aufbaus sind derartige Produkte auch nicht in vollem Umfang zufriedenstellend.

Eine weitere Möglichkeit, die in dem bereits erwähnten Buch von Sinnadurai auf Seite 245 beschrieben wird, sind sogenannte "Mutter-Tochter-Verbundplatten". Dabei wird die mit einem wärmeleitenden Metallkern ausgerüstete Leiterplatte, (die sogenannte "Tochter-Platte") mit einer in der Regel senkrecht dazu angeordneten und mit dieser über eine wärmeleitenden Befestigung verbundenen "Mutter-Platte", die als Träger für mehrere Tochterplatten dienen kann, verbunden. Auf Seite 245 des bereits erwähnten Buches ist der schematische Aufbau einer solchen Anordnung beschrieben. Es ist leicht ersichtlich, daß der Formgebung in diesen Systemen enge Grenzen gesetzt sind.

Aufgabe der vorliegenden Erfindung war es daher, Leiterplattensubstrate mit guter Wärmeleitfähigkeit zur Verfügung zu stellen, die auf einfache Weise in praktisch beliebiger Form hergestellt werden können.

Diese Aufgabe wird erfindungsgemäß durch die eingangs definierten Leiterplattensubstrate gelöst.

Als Komponente A) enthalten die erfindungsgemäßen Leiterplattensubstrate einen elektrisch und thermisch isolierenden Kunststoff, vorzugsweise ein Epoxiharz oder einen hochtemperaturbeständigen Thermoplasten aus der Gruppe der Polyarylethersulfone, Polyaryletherketone, Polyetherimide oder flüssig-kristallinen Polymeren (thermotropen Polymeren).

Epoxyharze für Verbundplatten sind dem Fachmann an sich bekannt und in der Literatur in großer Zahl beschrieben, so daß sich hierzu nähere Angaben erübrigen.

Auch Polyarylethersulfone sind in einer Vielzahl von Veröffentlichungen beschrieben, wobei hier nur stellvertretend die DE-AS 15 45 106, die EP-A 47 999, die US-A 4 175 175 und die GB-A 1 078 234 genannt seien. In diesen Patentschriften werden auch entsprechende Verfahren zur Herstellung von Polyarylethersulfonen beschrieben.

Auch Mischungen von Polyarylethersulfonen, wie sie in der EP-A 97 370 speziell für die Herstellung von Leiterplattensubstraten beschrieben werden, sind als Komponente A) der erfindungsgemäßen Leiterplattensubstrate geeignet.

Polyarylethersulfone auf der Basis von Bisphenol A und 4,4'-Dichlordiphenylsulfon bzw. auf der Basis von 4,4'-Dihydroxydiphenylsulfon und 4,4'-Dichlordiphenylsulfon aufgebaut sind, sind kommerziell im Handel erhältlich.

Auch Polyaryletherketone sind an sich bekannt und in einer Vielzahl von Veröffentlichungen beschrieben. Zum Teil sind derartige Produkte auch bereits kommerziell im Handel erhältlich (Stilan® der Fa. Raychem bzw. Victrex® der Firma ICI).

Derartige Produkte werden z. B. in der EP-A 1 879, der DE-A 26 50 943, und der EP-A 30 033 beschrieben, auf die hier wegen näherer Einzelheiten verwiesen sei.

Es versteht sich, . daß auch Etherketon/Ethersulfoncopolymere mit statistischem oder blockweisem Aufbau eingesetzt werden können. Derartige Produkte lassen sich nach an sich bekannten Verfahren zur Copolymerisation herstellen, indem die entsprechenden Monomeren entweder gleichzeitig oder aber in zeitlichem Abstand voneinander eingesetzt werden. Die erste Versuchsführung führt zu statistischen Copolymeren, während nach der zweiten Verfahrensvariante blockartig aufgebaute Polymere erhalten werden. Ein Verfahren zur Herstellung von Blockcopolymeren auf der Basis von Polyarylethersulfonen und Polyaryletherketonen wird z. B. in der EP-A 234 223 beschrieben.

Als nächste Gruppe hochtemperaturbeständiger Thermoplaste, die als Komponente A) verwendet werden können, sind die Polyetherimide zu nennen. Dabei handelt es sich um Polymere, die in der Regel durch Umsetzung von Di-(etheranhydriden) mit organischen Diaminen erhalten werden. Entsprechende Produkte sind in der US-A 3 847 867 der DE-A 24 37 286 und der DE-A 24 41 539 beschrieben. Ein bereits im Handel erhältliches kommerzielles Produkt dieses Typs ist Ultem® der Firma General Electric Company.

Schließlich sind als hochtemperaturbeständige Thermoplaste auch noch flüssig-kristalline Polymere, insbesondere thermotrope Polymere zu nennen. Dabei handelt es sich um thermoplastische Polymere, die anisotrope Eigenschaften in der Schmelzphase aufweisen, was zu interessanten mechanischen Eigenschaften führt. Derartige Produkte haben in den letzten Jahren aufgrund dieser Eigenschaften steigendes Interesse gefunden und sind in einer Vielzahl von Veröffentlichungen beschrieben. Als Beispiel sei hier nur das einschlägige Werk von A. Blumstein, Liquid Crystalline Order in Polymers, Academic Press, 1978 genannt.

Allgemein läßt sich sagen, daß thermotrope Polymere zu einem bestimmten Mindestanteil aus Einheiten aufgebaut sind, die linear sind und dadurch eine Steifheit der Molekülkette bewirken.

Als Beispiele für derartige Produkte seien hier ganz allgemein vollaromatische Polyester auf der Basis von para-Hydroxybenzoesäure, Terephthalsäure, Isophthalsäure, Hydrochinon, Dihydroxydiphenyl und deren Derivaten genannt. Diese Produkte können auch bis zu gewissen Grenzen nichtlineare Bausteine enthalten, solange dadurch die anisotropen, d. h. flüssigkristallinen Eigenschaften, nicht beeinträchtigt werden.

Aus dem Vorstehenden wird ersichtlich, daß es sich bei der als Komponente A) in den erfindungsgemäßen Leiterplattensubstraten verwendeten Komponente um an sich bekannte Materialien handelt, deren Verarbeitung beherrscht wird und im Fall der hochtemperaturbeständigen Thermoplasten durch rationelle Verfahren wie Spritzguß oder Extrusion erfolgen kann.

Als Komponente B) enthalten die erfindungsgemäßen Leiterplattensubstrate einen mit thermisch gut leitfähigen Füllstoffen ausgerüsteten Kunststoff, in der Regel wiederum einen hochtemperaturbeständigen Thermoplasten der Art, wie er auch als elektrisch isolierendes Substratmaterial verwendet wurde. Die hohe Temperaturbeständigkeit ist deswegen erforderlich, weil bei der Verlötung ·von elektronischen Bauelementen die aus den Leiterplattensubstraten hergestellten Leiterplatten kurzzeitig thermischen Belastungen von mehr als 200 insbesondere mehr als 230˚ ausgesetzt sind.

Als hochtemperaturbeständige Thermoplaste für die Komponente B) kommen die gleichen Polymerarten in Frage, wie sie vorstehend für die Komponente A) beschrieben wurden.

Bei den thermisch gut leitfähigen Füllstoffen handelt es sich vorteilhaft um metallische Füllstoffe, insbesondere Aluminiumflocken oder Aluminiumflitter, die zum einen wegen ihrer leichten Zugänglichkeit und zum anderen aus wirtschaftlichen Gründen bevorzugt werden.

Es ist jedoch prinzipiell auch möglich, andere Füllstoffe einzusetzen, die eine Verbesserung der thermischen Leitfähigkeit bewirken, z. B. andere metallische Füllstoffe wie Kupferflocken oder Kupferfasern und dergleichen.

Zur Herstellung der erfindungsgemäßen Leiterplattensubstrate ist es erforderlich, die Komponenten A) und B) mit ausreichender Haftfestigkeit miteinander zu verbinden. Dies kann z. B. durch Verpressen von Platten aus den Komponenten A) und Komponenten B), gegebenenfalls unter Mitverwendung bestimmter Klebstoffe als Haftvermittler, geschehen.

Falls sowohl die Komponente A) als auch die Komponente B) als Matrix ein thermoplastisches, hochtemperaturbeständiges Polymer enthält, bietet sich als besonders elegante Variante mit der Möglichkeit praktisch beliebiger Formgebung die Koextrusion bzw. der Zweikomponentenspritzguß als Herstellungsverfahren an. Derartige Techniken sind dem Fachmann an sich bekannt und in der einschlägigen Literatur beschrieben, so daß sich hier nähere Einzelheiten erübrigen.

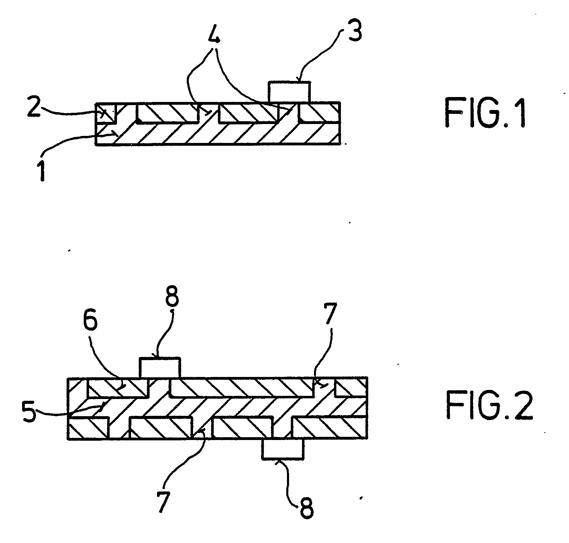

Die beigefügten Figuren 1 und 2 beschreiben zwei Ausgestaltungsmöglichkeiten erfindungsgemäßer Leiterplattensubstrate.

Figur 1 zeigt eine Anordnung aus einer Grundplatte eines mit Aluminiumflocken gefüllten Polyarylethersulfons 1, auf welchem eine Platte 2 aus thermisch und elektrisch isolierendem Polyarylethersulfon aufgebracht ist. Man erkennt, daß die auf der Platte 2 nach Metallbeschichtung aufzubringenden Bauteile 3 über die als Wärmesenken dienenden Durchbrüche 4 in Verbindung stehen, wobei natürlich darauf zu achten ist, daß die Lötverbindungen nicht mit dem metallgefüllten Polyarylethersulfon 2 in Berührung kommen, da es ansonsten zu Kurzschlüssen kommen kann.

Die in Figur 1 gezeigte Anordnung kann z. B. nach der "surface mounted device" Technik mit elektronischen Bauteilen bestückt werden, wobei jedoch bei dieser Ausgestaltung nur eine Seite bestückbar ist.

Abbildung 2 zeigt demgegenüber eine andere Anordnung, bei der ein mit Aluminiumflocken gefülltes Polyarylethersulfon 5 auf beiden Seiten mit thermisch und elektrisch isolierendem Polyarylethersulfon 6 so umspritzt ist, daß wärmeleitende Pfade 7 von beiden Bestückungsseiten aus vorhanden sind. In analoger Weise wie in Figur 1 können elektronische Bauteile 8 nunmehr auf beiden Seiten des Leiterplattensubstrats aufgebracht werden, d. h. die in Abbildung 2 gezeigte Ausführungsform läßt sich auf der Ober- und Unterseite mit elektronischen Bauteilen bestücken. Die Verbindungen von der Ober- zur Unterseite können beispielsweise durch elektrische Leiter, die gegenüber dem mit Aluminiumflocken gefüllten Polyarylethersulfon isoliert sind, hergestellt werden, falls eine solche Durchkontaktierung technisch nötig ist.

Die vorstehenden Ausführungen zeigen, daß sich die erfindungsgemäßen Leiterplattensubstrate durch eine verbesserte thermische Leitfähigkeit gegenüber den herkömmlichen Epoxyharz-Systemen bzw. Systemen auf der Basis thermisch nichtleitender hochtemperaturbeständiger Thermoplaste auszeichnen und auf einfache Weise, z. B. durch thermoplastische Verarbeitungsverfahren wie Extrusion oder Spritzguß, insbesondere Koextrusion oder Zweikomponentenspritzguß herstellbar sind.

**Ansprüche**

1. Leiterplattensubstrat mit guter Wärmeleitfähigkeit, aufgebaut aus einem Verbund aus

A) einem elektrisch und thermisch isolierenden Kunststoff und

B) einem mit thermisch gut leitfähigen Füllstoffen ausgerüsteten Kunststoff.

2. Leiterplattensubstrat nach Anspruch 1, dadurch gekennzeichnet, daß der Kunststoff A) ein Epoxyharz oder ein hochtemperaturbeständiger Thermoplast aus der Gruppe der Polyarylethersulfone, Polyaryletherketone, Polyetherimide oder thermotropen flüssigkristallinen Polymeren ist.

3. Leiterplattensubstrat nach den Ansprüchen 1 und 2, dadurch gekennzeichnet, daß der Kunststoff B) mit metallischen Füllstoffen wärmeleitfähig ausgerüstet ist.

4. Leiterplattensubstrat nach Anspruch 3, dadurch gekennzeichnet, daß der metallische Füllstoff Aluminiumflitter oder Aluminiumflocken sind.

FIG.1

FIG.2